# EUROPÄISCHE PATENTSCHRIFT

(11) **EP 0 406 483 B1**
(45) Veröffentlichungstag und Bekanntmachung des Hinweises auf die Patenterteilung: **16.06.1993**
(21) Anmeldenummer: 89122628.4
(22) Anmeldetag: 08.12.1989
(51) Int. Cl.: C23C 14/50, G02C 13/00

(54) **Vorrichtung zum Halten und Wenden von Linsen, insbesondere für in einer Hochvakuum-Aufdampfanlage oder -Sputteranlage zu beschichtende Brillenglaslinsen**
Apparatus for supporting and turning lenses, particularly for spectacle lenses to be coated in a high vacuum sputtering or evaporation plant
Appareil de support et d'orientation de verres optiques, en particulier de verres de lunettes à revêtir dans un dispositif d'évaporation sous vide ou de pulvérisation

(30) Priorität: 01.07.1989 DE 3921672
(43) Veröffentlichungstag der Anmeldung: 09.01.1991
(73) Patentinhaber: LEYBOLD AKTIENGESELLSCHAFT, D-63450 Hanau (DE)
(72) Erfinder: Kunkel, Georg, D-8751 Heigenbrücken (DE); Klingenstein, Dieter, D-6455 Erlensee (DE); Mahr, Heinz, D-6470 Büdingen 2 (DE); Fliedner, Michael, D-6454 Bruchköbel (DE)

(56) Entgegenhaltungen:
- FR-A- 2 602 244
- US-A- 4 344 383

## Beschreibung

Die Erfindung betrifft eine Vorrichtung zum Halten und Wenden von Linsen, insbesondere für in einer Hochvakuum-Aufdampfanlage oder -Sputteranlage zu beschichtende Brillenglaslinsen, mit die zu haltenden Linsen tragenden Ringpaaren, die ihrerseits mit einem Substrathalter kippbar gelagert sind, der in der Prozeßkammer der Hochvakuumanlage gehalten ist.

Bekannt ist eine Vakuum-Beschichtungsanlage zum Aufdampfen von Vergütungsschichten auf optische Substrate (DE-OS 37 15 831), wie Kunststoff-Brillengläser, welche auf Trägermittel aufspannbar sind, die in einem evakuierbaren Rezipienten oberhalb von Verdampfungsquellen umlaufen, wobei die Trägermittel eine Mehrzahl wenigstens angenähert kreissegmentförmige, flächige Trägerplatten umfassen, welche zueinander kalottenförmig sowie je um 180° wendbar an einer gemeinsamen Drehachse abgestützt sind, wobei jede Trägerplatte in Öffnungsbereichen eine Mehrzahl mit mindestens einer Haltefeder versehene Substrathalterungen aufweist, von denen mindestens eine nach beiden Seiten aus der Trägerplattenebene bis zu einem vorgegebenen Winkel heraus frei kippbar ist.

Jede frei kippbare Substrathalterung weist dabei eine das aufzunehmende Substrat teilweise umgreifende Fassung auf, in welcher das Substrat unter der Wirkung der Haltefeder steht und welche frei nach beiden Seiten hin kippbar über eine Kippachse an der Trägerplatte befestigt ist.

Weiterhin ist eine Linsenhalterung, insbesondere Halterung für zu reinigende und nachfolgend zu beschichtende Brillenglaslinsen bekannt (EP-A-0 215 261), welche als ein an seiner Innenseite Gabeln zur Aufnahme der zu haltenden Linsen tragender Ring ausgebildet ist, wobei der Ring elastisch verformbar ist und die Gabeln an zwei einander gegenüberliegenden Abschnitten der Ringinnenseite angeordnet sind.

Der vorliegenden Erfindung liegt nun die Aufgabe zugrunde, eine Vorrichtung zum Halten und Wenden von Linsen zu schaffen, die für kreisschalenförmig bzw. schirmförmig ausgeformte Substratträger geeignet ist bzw. bei der die Anordnung einer Vielzahl von Linsen auf einem derart ausgebildeten Substratträger möglich ist, die ein rasches Wenden der Linsen gegenüber der Beschichtungsquelle erlaubt, wobei die jeweils der Quelle zugekehrte eine Außenfläche der Linse den gleichen Abstand und Lage zur Quelle haben soll wie die jeweils andere Außenfläche der Linse nach dem Wenden.

Erfindungsgemäß wird diese Aufgabe dadurch gelöst, daß das schirmartig oder halbschalenförmig ausgeformte Blechteil, das den Substrathalter bildet, zumindest teilweise von einem sichelförmigen, einen Schieber oder Rechen bildenden Blechzuschnitt oder Profilelement übergriffen ist, wobei die dem Substrathalter zugewandte Kante des Rechens in einem geringen Abstand zur Außenfläche des Substrathalters von einem in der Prozeßkammer angeordneten Gleitstück oder Gelenkarm gehalten ist, wobei der Rechen in dieser Lage gegenüber der Oberseite des Substrathalters um die lotrechte Rotationsachse des Substrathalters oder in Richtung der Rotationsachse bewegbar ist und die an der dem Substratträger zugewandte Unterkante des Rechens angeordneten Zinken, zumindest zeitweise im Eingriff mit den Ritzeln, Zahnrädern oder Kulissen von den mit in auf dem Substrathalter angeordneten Lagerböcken oder Lagergabeln gelagerten Zapfen der Ringe gelangen.

Bei einer bevorzugten Ausführungsform ist der sichelförmige Rechen seinerseits von einem in Richtung der Rotationsachse verschiebbaren Gelenkarm, Gleitstück, Hubring oder Buchse und vom Hubglied einer an der Wand der Prozeßkammer bzw. des Rezipienten befestigten Hubvorrichtung, beispielsweise einem Hubmotor, gehalten und geführt.

Mit Vorteil weist der Schieber oder Rechen eine Vielzahl von Nasen oder Zinken auf, die sich etwa lotrecht zur Außenfläche des Substratträgers und bis in den Bereich der Ritzel oder Zahnräder der jeweiligen Ringe erstrecken.

Zweckmäßigerweise ist der sich in einer zur Rotationsachse des Substratträgers erstreckende Rechen mit seinem einen Ende an einen Hubring angelenkt und mit seinem anderen Ende mit einem den Substratträger umschließenden, in einer Ebene quer zur Rotationsachse vorgesehenen Koppelring verbunden, wobei der Koppelring seinerseits über ein Hubglied, beispielsweise der Kolbenstange eines Hubmotors, mit der Wand des Rezipienten in Verbindung steht und von diesem Hubmotor in Längsrichtung der Rotationsachse bewegbar ist.

Bei einer alternativen Ausführungsform sind die Zinken bewegbar am Rechen angelenkt, so daß sie beim Auflaufen auf eine Rampe einer blockierten bzw. drehfesten Kulisse in Richtung auf den Rechen zu eine Ausweichbewegung ausführen.

Um eine gleichmäßige Schwenkbewegung der Ringpaare zu gewährleisten, sind die am Rechen angelenkten Zinken mit Vorteil im Bereich ihrer mit den Kulissen zusammenwirkenden freien Enden forken- oder kammartig oder aber als Zahnsegmente ausgebildet, wobei die einzelnen Zinkenenden oder Zähne gemeinsam die Schwenkbewegung der Kulisse bzw. des Ringpaares bewirken, wenn sie in Eingriff mit der Kulisse gelangen.

Die Erfindung läßt die verschiedensten Ausführungsmöglichkeiten zu. Eine davon ist in den anhängenden Zeichnungen schematisch näher dargestellt, und zwar zeigen:
- Fig. 1: eine Hochvakuum-Aufdampfanlage, teilweise im Schnitt,
- Fig. 2: den kalottenförmig gebogenen Substratträger mit motorischem Antrieb gemäß Figur 1 im vergrößerten Maßstab, jedoch ohne die in jede ihrer Öffnungen einsetzbaren Ringpaare,
- Fig. 3 und 4: die beiden Ringe zur Halterung der Brillenglaslinse in perspektivischer Darstellung,
- Fig. 5: die beiden miteinander verbundenen Ringe gemäß den Figuren 3 und 4 und deren Lagerung auf dem Substratträger,
- Fig. 6: den Teillängsschnitt durch die beiden Ringe nach Figur 5 mit eingelegter Brillenglaslinse,
- Fig. 7: die Seitenansicht eines Rechens und die Substrathalterung im Teilschnitt und
- Fig. 8: die perspektivische Teildarstellung eines Rechens mit beweglich gelagerten Zinken und einem Ringpaar, dessen erster Ring mit einer Kulisse besonderer Konfiguration ausgestattet ist, wobei in der Zeichnung der Substrathalter nicht weiter dargestellt ist.

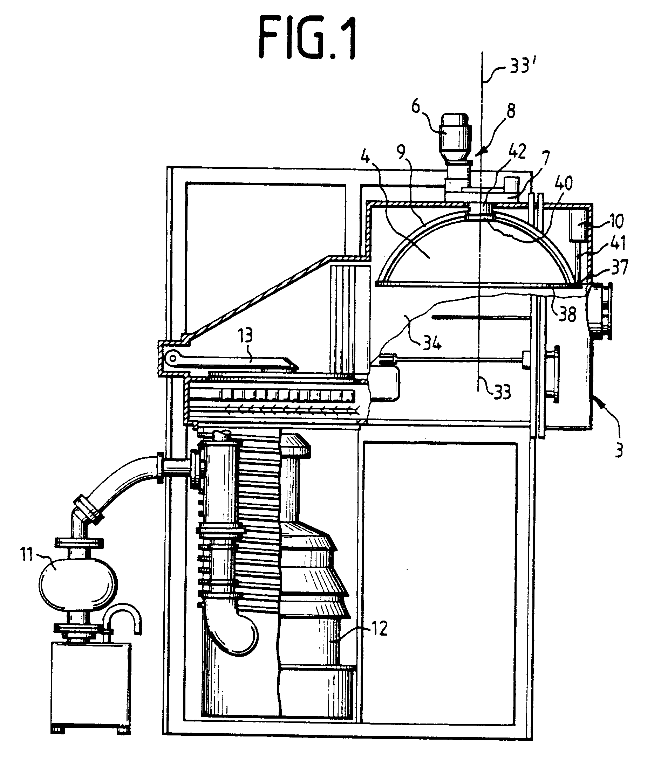

Die in Figur 1 dargestellte Hochvakuum-Aufdampfanlage besteht im wesentlichen aus einem Rezipienten 3 mit einer in diesem angeordneten, jedoch nicht näher dargestellten Verdampferquelle, einer kalottenförmig gebogenen Substrathalterung 4 aus einem mit einer Vielzahl von Öffnungen 5, 5', ... versehenen Blechzuschnitt, aus einer aus einem Motor 6 mit Getriebe 7 bestehenden Antriebseinheit 8, einem um eine vertikale Achse drehbaren, oberhalb der Substrathalterung 4 gelagerten Schieber oder Rechen 9 mit Hubmotor 10, einem Vorpumpsatz 11, einer Diffusionspumpe 12 und einem Vakuumventil 13.

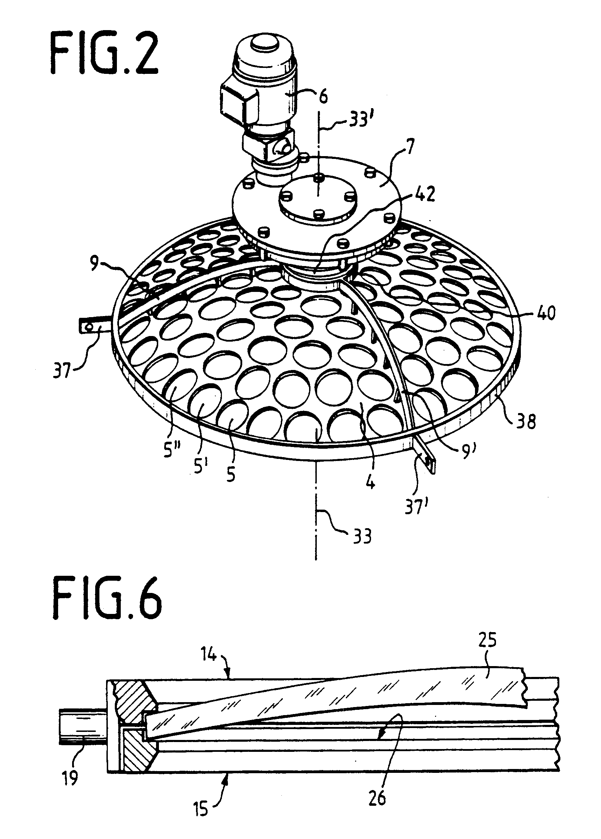

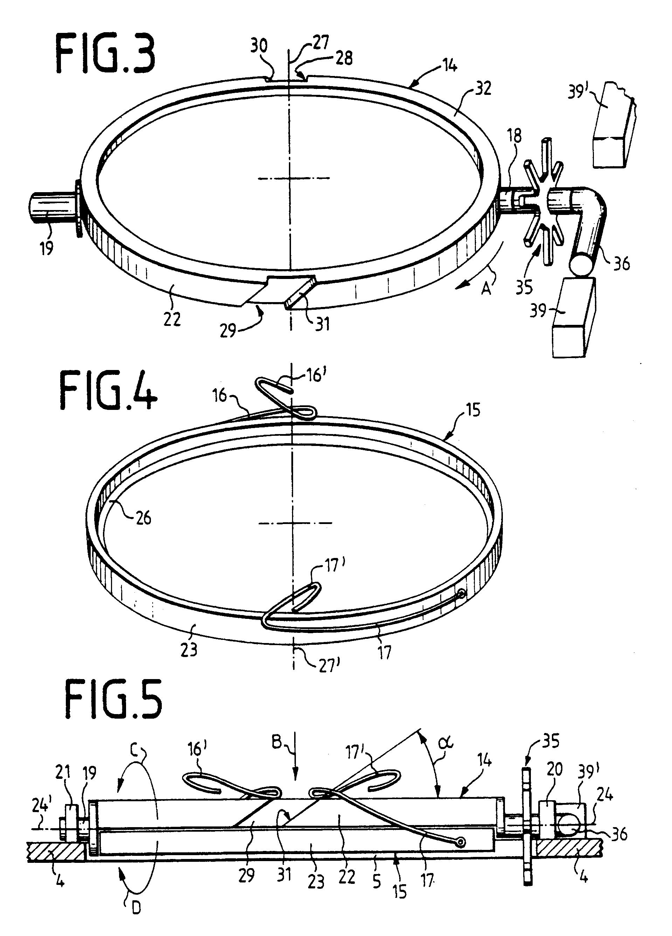

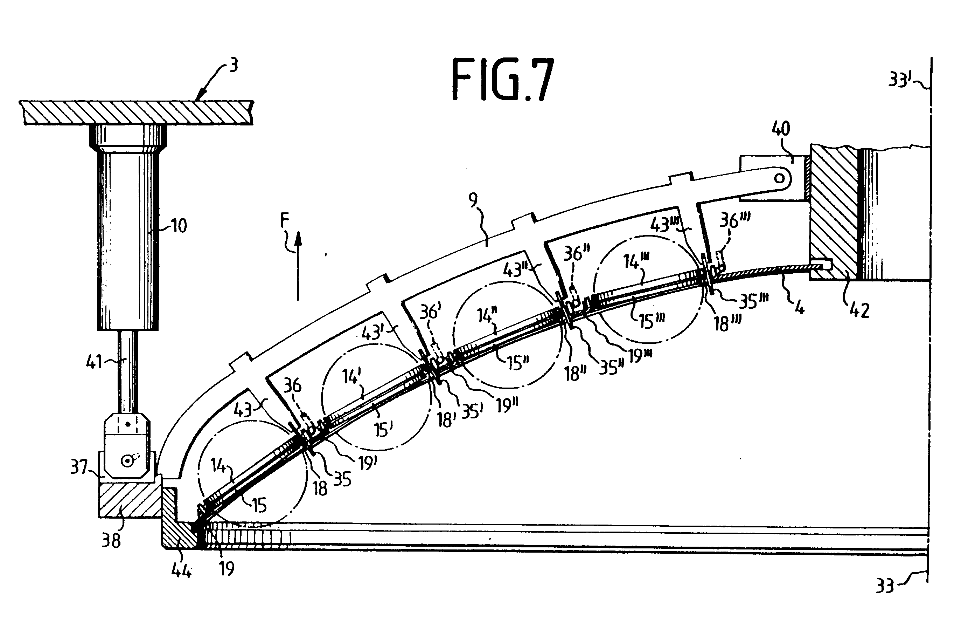

Die aus Figur 2 ersichtlichen Öffnungen 5, 5', ... in der Substrathalterung dienen der Aufnahme von Ringpaaren 14, 15, die mit Hilfe von Drahtfedern 16, 17 miteinander verbunden sind und über Zapfen 18, 19 in Lagergabeln 20, 21 einsetzbar sind, die sich jeweils paarweise in den Randbereichen der Öffnungen 5, 5', ... der Substrathalterung 4 befinden (in Figur 2 jedoch der besseren Übersichtlichkeit wegen nicht näher eingezeichnet sind). Gemäß den Figuren 3 und 5 ist der erste der beiden Ringe 14 an seiner radial äußeren Mantelfläche 22 mit den beiden einander diametral gegenüberliegenden Zapfen 18, 19 versehen, wobei die Längsachse 24, 24' bzw. die Rotationsachse der beiden Ringe etwa in der Berührungsebene dieser beiden Ringe 14, 15 verläuft.

Um die Brillenglaslinse 25 in die Ringe 14, 15 einlegen und diese anschließend miteinander verbinden zu können, wird die Brillenglaslinse 25 in einem ersten Arbeitsschritt auf die entsprechend bemessene Fase bzw. flanschförmige Stufe 26 des zweiten Rings 15 aufgelegt, dann wird in einem zweiten Arbeitsschritt der erste Ring 15 von oben her auf den zweiten Ring 15 so aufgelegt, daß die Rotationsachsen 27, 27' der beiden Ringe 14, 15 fluchten bzw. zusammenfallen; in einem dritten Arbeitsschritt wird der erste Ring 14 gegenüber dem zweiten Ring 15 in Pfeilrichtung A (Figur 3) gedreht, und zwar so lange, bis die buchtenförmigen, federnden Enden 16', 17' der Drahtfedern 16, 17 in die beiden Nuten 28, 29 hineingleiten, die in die radial äußere Mantelfläche 22 des ersten Rings 14 einander diametral gegenüberliegend eingeschnitten sind. Die buchtenförmigen Enden 16', 17' rutschen bei dieser Drehbewegung die Rampen 30, 31 der Nuten 28, 29 entlang, bis sie auf der Oberseite 32 des ersten Rings 14 aufliegen und so beide Ringe 14, 15 mit der dazwischenliegenden Brillenglaslinse 25 Zusammenhalten (siehe Figur 5).

Die beiden miteinander verklippten Ringe 14, 15 werden nun mit ihren Zapfen 18, 19 in Pfeilrichtung B in die beiden gabelförmigen bzw. U-förmigen Lagergabeln 20, 21 eingelegt, die sich paarweise jeweils an jeder Öffnung 5, 5', ... der Substrathalterung 4 befinden. Der Außendurchmesser der beiden Ringe 14, 15 bzw. der Innendurchmesser der Öffnungen 5, 5', ... ist dabei so bemessen, daß sich die beiden miteinander verklippten Ringe 14, 15, die zusammen ein Ringpaar bilden, in Pfeilrichtung C oder D um die Längsachse 24, 24' drehen lassen (Pfeilrichtung C, D in Figur 5). Diese Dreh- oder Schwenkbewegung ist mit Hilfe von im Rezipienten 3 gelagerten Rechen 9 bei geschlossener Prozeßkammer 34 durchführbar. Die Rechen 9, 9', ..., die als halbkreisförmige Blechzuschnitte mit an ihnen angeformten Zinken 43, 43', ... ausgebildet sind und bei einer Drehbewegung der Substrathalterung 4 um ihre Achse 33, 33' nach Art eines Kammes über die Oberseite der Substrathalterung 4 streichen, geraten dabei in Kontakt mit den Zähnen der auf jeweils einem Zapfen 18 des jeweils ersten Ringes 14 drehfest angeordneten Zahnräder 35, 35', ... und nehmen diese so lange mit, bis die Ringpaare 14, 15 jeweils eine 180° Schwenkbewegung um ihre Längsachsen 24, 24' vollführt haben. Ein an jedem Zapfen 18 vorgesehener Finger 36 legt sich dabei auf die Oberseite der Substrathalterung 4 auf und verhindert eine weitere Drehbewegung bzw. wird in dieser Position von einem der Magnete 39, 39' gehalten, die im Bereich der Finger 36, 36', ... jeweils im Abstand zueinander auf der Oberseite der Substrathalterung 4 fest angeordnet sind. Die beiden Magnete 39, 39' eines Magnetpaares tragen dafür Sorge, daß das zugeordnete Ringpaar 14, 15 während des Wendevorgangs nicht in einer Zwischenposition bzw. in einer instabilen Position stehenbleibt oder nach dem Wendevorgang in diese zurückschwingt. Der in die Zahnräder 35 der jeweiligen Ringpaare 14, 15 eingreifende Rechen 9, 9', ... ermöglicht also eine Schwenkbewegung der einzelnen Ringpaare bzw. der in diese eingelegten Brillenglaslinsen 25 während des laufenden Beschichtungsvorgangs, d. h. bei geschlossenem Rezipienten 3, wozu besondere Hubmotore 10 mit Hubgliedern 41 und Gelenken 37 vorgesehen sind, die dazu an einen Koppelring 38 angelenkt sind, der mehrere Rechen 9, 9' miteinander verbindet, wobei die Rechen 9, 9' außerdem über einen Hubring 40 aneinander gekoppelt sind, der auf dem Lagerrohr 42 der Antriebseinheit 8 verschiebbar gehalten und geführt ist.

Werden die Hubmotore 10 (von denen in den Figuren 1 und 7 nur jeweils einer dargestellt ist) aktiviert, dann bewegen sich die Rechen 9, 9', ... zusammen mit dem Koppelring 38 in Pfeilrichtung F aus der in Figur 7 gezeigten unteren Position in eine obere Position, in der die einzelnen Zinken 43, 43', ... der Rechen 9, 9', ... außer Eingriff mit den zugehörigen Zahnrädern 35, 35', ... gelangen, so daß der Substratträger 4 nun frei rotieren kann und die Ringpaare 14, 15 bzw. 14', 15' bzw. 14'', 15'' bzw. 14''', 15''' in ihrer Ruhestellung verbleiben.

Es sei noch erwähnt, daß der schirmartig bzw. halbschalenförmig ausgebildete Substratträger an seinem unteren kreisringförmigen Rand mit einem Versteifungsring 44 versehen ist, der eine zuverlässige Führungsfläche für den in Pfeilrichtung F bewegbaren Koppelring 38 bildet. Da bei dem in den Zeichnungen dargestellten Ausführungsbeispiel drei Rechen 9 jeweils zwischen Hubring 40 und Koppelring 38 eingespannt sind, lassen sich auch alle drei Rechen 9 in Pfeilrichtung F wie eine geschlossene Haube anheben, so daß die zahlreichen Zinken 43, 43', ... gleichzeitig außer Eingriff mit den Zahnrädern 35, 35', ... gelangen.

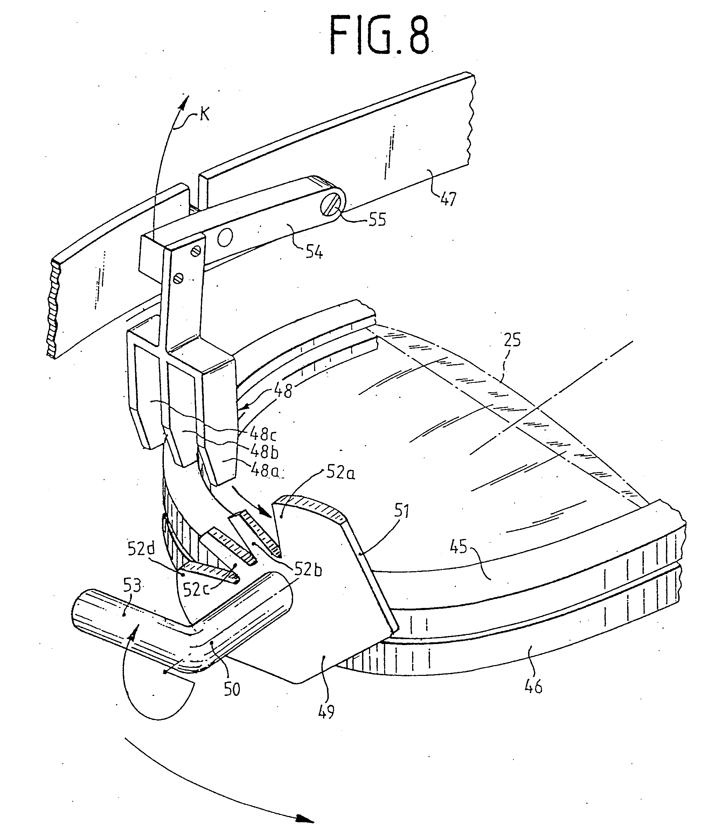

Bei der Ausführungsform der Vorrichtung gemäß Figur 8 sind an den Rechen 47 Zinken 48 angelenkt, die forkenförmig ausgeformt sind, d. h. der im Eingriff mit der Kulisse 49 gelangende Teil der Zinken 48 ist hier jeweils mit drei Zinkenenden 48a, 48b, 48c versehen, so daß die Drehbewegung der Kulisse 49, die jeweils mit mehreren Zähnen 52a, 52b, 52c, 52d ausgestattet ist, besonders gleichförmig und leicht vonstatten geht. Jede Kulisse 49 ist außerdem mit Rampen 51 versehen, die ein Blockieren der Vorrichtung verhindern, wenn beispielsweise die Drehbewegung bereits erfolgt ist und das Ringpaar 45, 46 durch das Aufliegen des Fingers 53 auf der Substrathalterung 4 an einer Drehbewegung gehindert ist. In einem solchen Falle läuft der Zinken 48 auf die jeweilige Rampe 51 auf und wird von dieser nach oben gedrückt, so daß durch die Schwenkbewegung in Pfeilrichtung K die Zinkenenden 48a, 48b, 48c außer Eingriff sind. Wie die Zeichnung zeigt, ist der Zinken 48 an einem Schwenkarm 54 befestigt, der seinerseits mit einem Bolzen 55 an dem Rechen 47 angelenkt ist.

### Auflistung der Einzelteile

- 3: Rezipient
- 4: Substrathalterung
- 5, 5', ...: Öffnung
- 6: Motor
- 7: Getriebe
- 8: Antriebseinheit
- 9, 9', ...: Rechen
- 10: Hubmotor
- 11: Vorpumpsatz
- 12: Diffusionspumpe
- 13: Vakuumventil
- 14: erster Ring
- 15: zweiter Ring
- 16, 16': Drahtfeder
- 17, 17': Drahtfeder
- 18: Zapfen
- 19: Zapfen
- 20: Lagergabel
- 21: Lagergabel
- 22: radial äußere Mantelfläche
- 23: radial äußere Mantelfläche
- 24, 24': Längsachse
- 25: Brillenglaslinse
- 26: flanschförmige Stufe
- 27, 27': Rotationsachse
- 28: Nut
- 29: Nut
- 30: Rampe
- 31: Rampe
- 32: Ringoberseite
- 33: Drehachse
- 34: Prozeßkammer
- 35, 35', ...: Zahnrad
- 36: Finger
- 37: Gelenk
- 38: Koppelring
- 39, 39': Magnet
- 40: Hubring, Gleitstück
- 41: Hubglied
- 42: Lagerrohr
- 43, 43', ...: Nase, Zinken
- 44: Versteifungsring
- 45: erster Ring
- 46: zweiter Ring
- 47: Rechen
- 48, 48a, 48b, 48c: Zinken
- 49: Kulisse
- 50: Zapfen
- 51, 51': Rampe
- 52a, 52b, 52c, 52d: Zahn
- 53: Finger
- 54: Schwenkarm
- 55: Bolzen

## Patentansprüche

1. Vorrichtung zum Halten und Wenden von Linsen (25), insbesondere für in einer Hochvakuum-Aufdampfanlage oder -Sputteranlage zu beschichtende Brillenglaslinsen, mit die zu haltenden Linsen (25) tragenden Ringpaaren (14, 14',... 15, 15'...), die ihrerseits am Substrathalter (4) kippbar sind, der in der Prozeßkammer (3) der Hochvakuumanlage gehalten ist, **dadurch gekennzeichnet**, daß das schirmartig oder halbschalenförmig ausgeformte Blechteil, das den Substrathalter (4) bildet, zumindest teilweise von einem sichelförmigen, einen Schieber oder Rechen (9,9'...) bildenden Blechzuschnitt oder Profilelement übergriffen ist, wobei die dem Substrathalter (4) zugewandte Kante des Rechens (9,9'..., 47) in einem geringen Abstand zur Außenfläche des Substrathalters (4) von einem in der Prozeßkammer (1) angeordneten Gleitstück (40) oder Gelenkarm gehalten ist, wobei der Rechen (9,9'...) in dieser Lage gegenüber der Oberseite des Substrathalters (4) um die lotrechte Rotationsachse (33') des Substrathalters oder in Richtung der Rotationsachse bewegbar ist und die an der dem Substratträger (4) zugewandte Unterkante des Rechens (9,9'..., 47) angeordneten Zinken (43,43'... bzw. 48), zumindest zeitweise in Eingriff mit den Ritzeln, Zahnrädern (35,35'...) oder Kulissen (49) von den mit in auf dem Substrathalter (4) angeordneten Lagerböcken oder Lagergabeln (20,21) gelagerten Zapfen (18, 19 bzw. 18',19 bzw. 50) der Ringe (14, 14'...) gelangen.

2. Vorrichtung zum Halten und Wenden von Linsen, nach Anspruch 1 **dadurch gekennnzeichnet,** daß der sichelförmige Rechen (9 bzw. 47) seinerseits von einem in Richtung der Rotationsachse (33, 33') verschiebbaren Gelenkarm, Gleitstück, Hubring oder Buchse (40) und vom Hubglied (41) einer an der Wand der Prozeßkammer (34) bzw. des Rezipienten (3) befestigten Hubvorrichtung, beispielsweise einem Hubmotor (10), gehalten und geführt ist.

3. Vorrichtung nach Anspruch 2, **dadurch gekennzeichnet**, daß der Schieber oder Rechen (9, 9', ... bzw. 47) eine Vielzahl von Nasen oder Zinken (43, 43', ... bzw. 48) aufweist, die sich etwa lotrecht zur Außenfläche des Substratträgers (4) und bis in den Bereich der Ritzel, Zahnräder (35, 35', ...) oder Kulissen (49) der jeweiligen Ringe (14, 14', ... bzw. 45, 46) erstrecken.

4. Vorrichtung nach den Ansprüchen 2 und 3, **dadurch gekennzeichnet,** daß der sich in einer zur Rotationsachse (33, 33') des Substratträgers (4) erstreckende Rechen (9, 9', ... bzw. 47) mit seinem einen Ende an einen Hubring (40) angelenkt ist und mit seinem anderen Ende mit einem den Substratträger (4) umschließenden, in einer Ebene quer zur Rotationsachse (33, 33') vorgesehenen Koppelring (38) verbunden ist, wobei der Koppelring (38) seinerseits über ein Hubglied (41), beispielsweise der Kolbenstange eines Hubmotors (10), mit der Wand des Rezipienten (3) in Verbindung steht und von diesem Hubmotor (10) in Längsrichtung der Rotationsachse (33, 33') bewegbar ist (Pfeilrichtung F).

5. Vorrichtung nach einem oder mehreren der vorhergehenden Ansprüche, **dadurch gekennzeichnet**, daß die Zinken (48) bewegbar am Rechen (47) angelenkt sind und beim Auflaufen auf eine Rampe (51) einer blockierten bzw. rotationsfesten Kulisse (49) in Richtung auf den Rechen (47) zu eine Ausweichbewegung (Pfeilrichtung K) ausführen und die Kulisse (49) überratschen (überspringen).

6. Vorrichtung nach Anspruch 5, **dadurch gekennzeichnet**, daß die am Rechen (47) angelenkten Zinken (48) im Bereich ihrer mit den Kulissen (49) zusammenwirkenden freien Enden forkenförmig oder kammartig oder aber als Zahnsegmente ausgebildet sind, wobei die einzelnen Zinkenenden (48a, 48b, 48c) oder Zähne gemeinsam die Schwenkbewegung der Kulisse (49) bzw. des mit ihr verbundenen Ringpaares (45, 46) bewirken.

## Claims

1. Apparatus for holding and turning lenses (25), in particular for spectacle lenses to be coated in a high-vacuum metallising or cathode sputtering installation, having ring pairs (14, 14' ... 15, 15' ...) which carry the lenses (25) to be held and are tiltable on the substrate support (4), which is held in the processing chamber (3) of the high-vacuum installation, characterised in that the screen-like or half-shell-shaped sheet-metal part forming the substrate support (4) is at least partly covered by a sickle-shaped sheet-metal blank or profile element forming a slide or rake (9, 9'...), and the edge of the rake (9, 9'..., 47) associated with the substrate support (4) is held at a short distance from the outer face of the substrate support (4) by a slide member (40) or articulated arm located in the processing chamber (1), and in this position the rake (9, 9'...) is movable relative to the upper side of the substrate support (4) about the vertical axis of rotation (33') of the substrate support or in the direction of the axis of rotation, and the prongs (43, 43'... and 48 respectively) located on the lower edge of the rake (9, 9..., 47) associated with the substrate support (4) enter into at least temporary engagement with the pinions, gearwheels (35, 35'...) or links (49) of the lugs (18, 19 and 18', 19' and 50 respectively) of the rings (14, 14'...) mounted in bearing blocks or bearing forks (20, 21) located on the substrate support (4).

2. Apparatus for holding and turning lenses according to claim 1, characterised in that the sickle-shaped rake (9 and 47 respectively) is held and guided by an articulated arm, slide member, lifting ring or collar (40) displaceable in the direction of the axis of rotation (33, 33') and by the lifting member (41) of a lifting device, for example a lifting motor (10), fixed to the wall of the processing chamber (34) or receptacle (3).

3. Apparatus according to claim 2, characterised in that the slide or rake (9, 9;,... and 47 respectively) has a plurality of lugs or prongs (43, 43', ... and 48 respectively) extending approximately perpendicular to the outer face of the substrate support (4) and into the vicinity of the pinions, gearwheels (35, 35',...) or links (49) of the respective rings (14, 14',... and 45, 46 respectively).

4. Apparatus according to claims 2 and 3, characterised in that the rake (9, 9',... and 47 respectively) extending in a to the axis of rotation (33, 33') of the substrate support (4) is coupled by one end to a lifting ring (40) and is connected by the other end to a coupling ring (38) surrounding the substrate support (4) and provided in a plane transverse to the axis of rotation (33, 33'), and the coupling ring (38) communicates with the wall of the receptacle (3) via a lifting member (41), for example the piston rod of a lifting motor (10), and is movable in the longitudinal direction of the axis of rotation (33, 33') by said lifting motor (10) (arrow direction F).

5. Apparatus according to one or more of the preceding claims, characterised in that the prongs (48) are movably coupled to the rake (47) and, when said prongs run on to a slope (51) of a locked or non-rotatable link (49) in the direction of the rake (47), they are deflected (arrow direction K) and jump over the link (49).

6. Apparatus according to claim 5, characterised in that the prongs (48) coupled to the rake (47) are fork-shaped or comb-shaped or are formed as tooth segments at their free ends cooperating with the links (49), and the individual prong ends (48a, 48b, 48c) or teeth together effect the pivoting movement of the link (49) or of the respectively associated ring pair (45, 46).

## Revendications

1. Dispositif pour porter et retourner les lentilles (25), en particulier pour des verres de lunettes à revêtir dans une installation de revêtement par vaporisation sous vide élevé ou une installation de crépitement sous vide élevé, dispositif comportant des paires d'anneaux (14, 14',... 15, 15'...), qui portent les lentilles à porter (25) et qui, de leur côté, peuvent basculer sur le porte-substrats (4), lui-même maintenu dans la chambre de processus (3) de l'installation sous vide élevé, dispositif caractérisé par le fait que la pièce de tôle, en forme d'écran ou de demi-coquille, qui constitue le porte-substrats (4), vient, au moins partiellement, en prise, par dessus, avec un tronçon de tôle, ou élément de profilé, en forme de lunule et constituant un racloir ou un râteau (9, 9'...), dispositif dans lequel le bord du râteau (9, 9', ..., 47) situé du côté du porte-substrats (4) est tenu, à faible distance de la surface extérieure du porte-substrats (4), par un organe coulissant (40) ou bras articulé disposé dans la chambre de processus (1), dans lequel le râteau (9, 9'...) peut, dans cette position, se déplacer par rapport à la face supérieure du porte-substrats (4), autour de l'axe de rotation vertical (33') du porte-substrats ou bien selon la direction de cet axe de rotation et dans lequel les dents (43, 43'... ou 48), disposées sur le bord inférieur du râteau (9, 9'..., 47) situé du côté du porte-substrats (4) viennent, au moins partiellement, en prise avec les pignons, roues dentées (35, 35'...) ou coulisseaux (49) des tourillons (18, 19 ou 18', 19' ou 50), portés dans les supports ou chapes (20, 21) disposés sur le porte-substrats (4), des anneaux (14, 14'...).

2. Dispositif pour porter et retourner des lentilles, selon la revendication 1, caractérisé par le fait que le râteau en forme de lunule (9 ou 47) est, lui-même, porté et guidé par un bras articulé, un élément coulissant, une couronne de levage ou un manchon (40) pouvant coulisser selon la direction de l'axe de rotation (33, 33') et par un organe de levage (41) d'un dispositif de levage, par exemple un moteur de levage (10), fixé à la paroi de la chambre de processus (34) du récipient (3).

3. Dispositif selon la revendication 2, caractérisé par le fait que le racloir ou râteau (9, 9',... ou 47) présente une pluralité de talons ou dents (43, 43',... ou 48) qui s'étendent à peu près verticalement jusqu'à la surface extérieure du porte-substrats (4) et jusque dans la zone des pignons, roues dentées (35, 35',...) ou coulisseaux (49) des anneaux respectifs (14, 14', ... ou 45, 46).

4. Dispositif selon les revendications 2 et 3, caractérisé par le fait que le râteau (9, 9',... ou 47), qui, d'un côté, s'étend jusqu'à l'axe de rotation (33, 33') du porte-substrats (4), est, par l'une de ses extrémités, articulé à une couronne de levage (40) et, par son autre extrémité, relié à une couronne de couplage enserrant le porte-substrats (4) et prévue dans un plan perpendiculaire à l'axe de rotation (33, 33'), étant précisé que de son côté, la couronne de couplage (38) est reliée, par l'intermédiaire d'un organe de levage (41), par exemple de la tige de piston d'un moteur de levage (10), avec la paroi du récipient (3) et peut être déplacée par ce moteur de levage (10) selon la direction longitudinale de l'axe de rotation (33, 33') (sens de la flèche F).

5. Dispositif selon une ou plusieurs des revendications précédentes, caractérisé par le fait que les dents (48) sont articulées, mobiles, sur le râteau (47) et, en montant sur une rampe (51) d'un coulisseau (49), bloqué ou fixe en rotation, exécutent un mouvement d'évitement en direction du râteau (47) (sens de la flèche K) et passent (sautent) par-dessus le coulisseau (49).

6. Dispositif selon la revendication 5, caractérisé par le fait que les dents (48), articulées sur le râteau (47), ont, dans la zone de leurs extrémités libres collaborant avec les coulisseaux (49), la forme de fourchette, ou de peigne, ou bien de segments de dents d'engrenage, étant précisé que les différentes extrémités de dents (48a, 48b, 48c) ou les différentes dents d'engrenage opèrent en commun le mouvement de pivotement du coulisseau (49) ou de la paire d'anneaux (45, 46) qui lui est liée.
